# EUROPEAN PATENT APPLICATION

(11) **EP 4 831 126 A1**
(43) Date of publication of application: **28.10.2026**
(21) Application number: 24907368.5
(22) Date of filing: 16.12.2024
(51) Int. Cl.: C01B 33/141, C09K 3/14, H01L 21/304

(54) **SILICA PARTICLE AND PRODUCTION METHOD THEREFOR, SILICA SOL, POLISHING COMPOSITION, POLISHING METHOD, METHOD FOR PRODUCING SEMICONDUCTOR WAFER, AND METHOD FOR PRODUCING SEMICONDUCTOR DEVICE**

(30) Priority: 19.12.2023 JP 2023214121
(71) Applicant: Mitsubishi Chemical Corporation, Tokyo 100-8251 (JP)
(72) Inventor: SHIMADA, Yuta, Tokyo 100-8251 (JP); YONEMORI, Tsutomu, Tokyo 100-8251 (JP)
(74) Representative: Hoffmann Eitle
(86) International application number: PCT/JP2024/044414
(87) International publication number: WO 2025/134983

(57) **Abstract**

An object of the present invention is to provide a silica particle, a silica sol, and a polishing composition having excellent polishing rate, a polishing method excellent in productivity of an object to be polished, a method for producing a semiconductor wafer, and a method for producing a semiconductor device.
The present invention relates to silica particles satisfying the following formulae (1a) and (1b) when an average secondary particle size is x (nm) and a true specific gravity is y (g/mL). $y > - 0.0018 x + 2.032$ (1a) $x > 50$ (1b).

## Description

### TECHNICAL FIELD

The present invention relates to silica particles, a method for producing the silica particles, a silica sol, a polishing composition, a polishing method, a method for producing a semiconductor wafer, and a method for producing a semiconductor device.

### BACKGROUND ART

As a method of polishing a surface of a material such as a metal or an inorganic compound, a polishing method using a polishing solution is known.

Among them, in final finish polishing of a prime silicon wafer for a semiconductor or a recycled silicon wafer thereof, and in chemical mechanical polishing (CMP) for planarization of an interlayer insulating film, formation of a metal plug, and formation of embedded wiring and the like during producing a semiconductor device, the surface state thereof greatly affects the semiconductor characteristics, so that the surfaces and end faces of these components are required to be polished with extremely high accuracy.

In such precise polishing, a polishing composition containing silica particles is adopted, and colloidal silica is widely used as abrasive grains which are main components thereof. Colloidal silica is known, depending on the producing method thereof, such as by thermal decomposition of silicon tetrachloride (fumed silica or the like), deionization of alkali silicate such as water glass, hydrolysis reaction and condensation reaction of alkoxysilane (generally referred to as "sol-gel method").

Many studies have been made on methods for producing silica particles. For example, Patent Literatures 1 and 2 disclose a method for producing silica particles by subjecting an alkoxysilane to a hydrolysis reaction and a condensation reaction.

### CITATION LIST

### PATENT LITERATURE

Patent Literature 1: JP H11-60232 A
Patent Literature 2: JP 2019-89692 A

### SUMMARY OF INVENTION

### TECHNICAL PROBLEM

Conventionally, when the particle diameter of the silica particles is increased, the true specific gravity decreases, and when the true specific gravity is increased, the particle diameter tends to decrease. In general, the larger the particle diameter of the silica particles, the faster the polishing rate. The higher the true specific gravity, the faster the polishing rate.

That is, the conventional silica particles have a trade-off relationship between the particle diameter and the true specific gravity, and it cannot be said that the polishing rate is sufficiently high.

Regarding the silica particles obtained by the production method disclosed in Patent Literatures 1 and 2, the true specific gravity and the particle diameter are not considered, and the polishing rate is not necessarily sufficient.

The present invention has been made in view of such a problem, and an object of the present invention is to provide silica particles, a silica sol, and a polishing composition having excellent polishing rate. Another object of the present invention is to provide a polishing method excellent in productivity of an object to be polished, a method for producing a semiconductor wafer, and a method for producing a semiconductor device.

### SOLUTION TO PROBLEM

As a result of intensive studies, the present inventors have found that the above problems can be solved by setting the relationship between the average secondary particle diameter and the true specific gravity within a predetermined range. Further, the present inventors have found that, in the method for producing silica particles, by adopting a predetermined step using a salt, it is possible to achieve both a large average secondary particle diameter and a high true specific gravity, thereby completing the present invention.

That is, the gist of the present invention is as follows.

Aspect 1 of the present invention relates to silica particles satisfying the following formulae (1a) and (1b), where x (nm) is an average secondary particle diameter and y (g/mL) is a true specific gravity: $y > - 0.0018 x + 2.032$ (1a) $x > 50$ (1b).

Aspect 2 of the present invention relates to silica particles satisfying the following formula (1c) in the silica particles of the aspect 1: $y > - 0.0018 x + 2.062$ (1c).

Aspect 3 of the present invention relates to silica particles satisfying the following formula (1d) in the silica particles of the aspect 1 or 2: $x \geq 55$ (1d).

Aspect 4 of the present invention relates to silica particles having a metal impurity content of 5 ppm by mass or less in the silica particles of any one of the aspects 1 to 3.

Aspect 5 of the present invention relates to silica particles satisfying the following formula (1e) in the silica particles of any one of the aspects 1 to 4: $y \leq 2.10$ (1e).

Aspect 6 of the present invention relates to silica particles having a refractive index of 1.380 or more in the silica particles of any one of the aspects 1 to 5.

Aspect 7 of the present invention relates to silica particles having an average primary particle diameter of 15 nm to 700 nm in the silica particles of any one of the aspects 1 to 6.

Aspect 8 of the present invention relates to silica particles having an amine content of less than 5 µmol/g in the silica particles of any one of the aspects 1 to 7.

Aspect 9 of the present invention relates to a method for producing the silica particles according to any one of the aspects 1 to 8, the method including a step of subjecting alkoxysilane to hydrolysis and condensation reaction in a solution containing a salt.

Aspect 10 of the present invention relates to a method for producing silica particles according to the aspect 9, wherein the salt is decomposed or volatilized when heated to 100°C.

Aspect 11 of the present invention relates to a method for producing the silica particles according to the aspect 9 or 10, wherein alkoxysilane is subjected to hydrolysis and condensation reaction using an alkali catalyst.

Aspect 12 of the present invention relates to a method for producing the silica particles according to the aspect 11, wherein a molar ratio of an amount of the salt to an amount of the alkali catalyst contained in the solution at the start of the reaction in the step of subjecting alkoxysilane to hydrolysis and condensation reaction in the solution containing the salt is 1.0×10⁻⁴ to 4.5×10⁻².

Aspect 13 of the present invention relates to a silica sol containing the silica particles of any one of the aspects 1 to 8.

Aspect 14 of the present invention relates to a polishing composition containing the silica sol according to the aspect 13.

Aspect 15 of the present invention relates to a polishing method including polishing by using the polishing composition of the aspect 14.

Aspect 16 of the present invention relates to a method for producing a semiconductor wafer, the method including a step of polishing by using the polishing composition of the aspect 14.

Aspect 17 of the present invention relates to a method for producing semiconductor device, the method including a step of polishing by using the polishing composition of the aspect 14.

### ADVANTAGEOUS EFFECTS OF INVENTION

The silica particles, the silica sol, and the polishing composition of the present invention are excellent in polishing rate. The polishing method, the method for producing a semiconductor wafer, and the method for producing a semiconductor device according to the present invention are excellent in productivity of an object to be polished.

### DESCRIPTION OF EMBODIMENTS

The present invention will be described in detail below, but the present invention is not limited to the following embodiments, and various modifications can be made within the scope of the gist thereof. In the present specification, a numerical range expressed by using the term "to" means that the numerical values or physical property values before and after "to" are included in the numerical range.

### [Silica Particles]

The silica particles according to the present embodiment satisfy the following formulae (1a) and (1b) when the average secondary particle diameter is x (nm) and the true specific gravity is y (g/mL): $y > - 0.0018 x + 2.032$ (1a) $x > 50$ 1(b)

The silica particles satisfying the above formulae (1a) and (1b) are excellent in polishing rate.

When the silica particles do not satisfy at least one of the above formulae (1a) and (1b), the physical contact force between the silica particles and the object to be polished decreases, and thus the polishing rate is inferior.

The definition of the average secondary particle diameter in the present specification is as described later.

In the present specification, the true specific gravity means the average density of the silica particles. The true specific gravity of the silica particles can be measured by an ethanol substitution method.

The true specific gravity of the silica particles can be set to a desired range depending on the production conditions of the silica particles.

For example, when the reaction temperature of the hydrolysis and condensation reaction of the tetraalkoxysilane is high, the true specific gravity of the silica particles tends to increase, whereas when the reaction temperature of the reaction is low, the true specific gravity of the silica particles tends to decrease.

The average secondary particle diameter x (nm) and the true specific gravity y (g/mL) of the silica particles according to the present embodiment are not particularly limited as long as the above formulae (1a) and (1b) are satisfied, but x is more than 50 nm, preferably 55 nm or more, more preferably 65 nm or more, even more preferably 75 nm or more, particularly preferably 100 nm or more, and most preferably 135 nm or more. In addition, x is preferably 1000 nm or less, more preferably 500 nm or less, still more preferably 400 nm or less, and particularly preferably 300 nm or less. On the other hand, y is preferably 1.70 g/mL or more, more preferably 1.75 g/mL or more, still more preferably 1.82 g/mL or more, and particularly preferably 1.88 g/mL or more. The upper limit of y is generally 2.20 g/mL or less in the case of amorphous silica. In addition, the value of y is preferably 2.10 g/mL or less, more preferably 2.05 g/mL or less, and particularly preferably 2.00 g/mL or less, because the particles are too hard to cause scratches during polishing.

When x is greater than 50 nm, the physical contact force of the silica particles to the object to be polished increases, and the polishing rate is excellent.

When x is 1000 nm or less, scratches on the object to be polished can be suppressed, which is preferable.

On the other hand, when y is 1.70 g/mL or more, physical contact force of the silica particles to an object to be polished increases, which is preferable.

When y is 2.20 g/mL or less, scratches on the object to be polished can be suppressed, which is preferable.

From the viewpoint of increasing the physical contact force of the silica particles to the object to be polished and increasing the polishing rate, the silica particles according to the present embodiment preferably satisfy the following formula (1c): $y > - 0.0018 x + 2.062$ (1c).

The definitions of x and y in the above formula (1c) are as described for the above formulae (1a) and (1b).

From the viewpoint of increasing the physical contact force of the silica particles to the object to be polished and increasing the polishing rate, it is preferable to increase the true specific gravity and the average secondary particle diameter at the same time, and this can be rephrased as follows.

That is, when x > 50, it is preferable that y ≥ 1.93. In addition, when x ≥ 65, it is preferable that y ≥ 1.87. In addition, when x ≥ 85, it is preferable that y ≥ 1.81. In addition, when x ≥ 140, it is preferable that y ≥ 1.75. In addition, when x ≥ 190, it is preferable that y ≥ 1.70.

From the viewpoint of improving the physical contact force of the silica particles to the object to be polished, the silica particles according to the present embodiment preferably satisfy the following formula (1d): $x \geq 55$ (1d).

The definition of x in the above formula (1d) is as described for the above formulae (1a) and (1b).

Furthermore, from the viewpoint of providing moderately flexible silica particles and preventing scratches on an object to be polished during polishing, the silica particles according to the present embodiment preferably satisfy the following formula (1e): $y \leq 2.10$ (1c).

The definition of y in the above formula (1e) is as described for the above formulae (1a) and (1b).

When the refractive index of the silica particles is large, since the atom density of the silica particles is high and the mechanical strength is easily maintained, the refractive index of the silica particles according to the present embodiment is preferably 1.380 or more, more preferably 1.390 or more, and still more preferably 1.400 or more. In addition, since silica preferably maintains an amorphous structure, it is preferably 1.550 or less, more preferably 1.500 or less, and still more preferably 1.450 or less. Various methods can be considered as a method for controlling the refractive index of the silica particles, and for example, the refractive index of the silica particles can be increased by increasing the reaction temperature.

The refractive index of the silica particles is obtained by adding special grade 2-propanol and special grade toluene in different ratios to a container containing silica particles, measuring the supernatant when the silica particles in the container become transparent with an Abbe refractometer, and setting the refractive index at that time as the refractive index of the silica particles.

The silica particles according to the present embodiment are preferably amorphous. In this case, a silanol group is appropriately present on the surface of the silica particles, and in the step of polishing the object to be polished, chemical interaction occurs between the silica particles and the object to be polished via the silanol group, and polishing proceeds favorably.

The fact that the silica particles are amorphous can be confirmed by a halo pattern in wide-angle X-ray scattering measurement.

The metal impurity content of the silica particles according to the present embodiment is preferably 5 ppm by mass or less, and more preferably 1 ppm by mass or less.

The lower limit of the metal impurity content is not particularly limited, but the metal impurity is preferably substantially not included. The term "substantially not included" means that it is equal to or less than the detection limit of the measurement method described later, in other words, 0 ppm by mass.

When the metal impurity content of the silica particles is 5 ppm by mass or less, contamination due to adhesion of metal impurities to the surface of the object to be polished in polishing of a silicon wafer of a semiconductor device and influence on wafer characteristics due to the contamination are reduced, which is preferable. In addition, deterioration of quality due to diffusion of metal impurities adhering to the surface of the object to be polished into the wafer and deterioration of performance of the semiconductor device produced by such a wafer are reduced, which is preferable.

Further, when the metal impurity content of the silica particles is 5 ppm by mass or less, a change in the chemical properties (acidity or the like) of the surface silanol group due to the occurrence of a coordinate interaction between the surface silanol group exhibiting acidity and the metal impurities, or an influence on the polishing rate due to a change in a three-dimensional environment (easiness of aggregation of silica particles) on the surface of the silica particles is reduced, which is preferable.

The metal impurity content of the silica particles in the present specification is a value measured by the high-frequency inductively coupled plasma mass spectrometry (ICP-MS). Specifically, silica sol containing 0.4 g of silica particles is accurately weighed, sulfuric acid and hydrofluoric acid are added thereto, heated, dissolved, and evaporated, pure water is added to the remaining sulfuric acid droplets so that the total amount is accurately 10 g, thereby preparing a test solution, and the test solution is measured using a high-frequency inductively coupled plasma mass spectrometer. The target metal is sodium, potassium, iron, aluminum, calcium, magnesium, zinc, cobalt, chromium, copper, manganese, lead, titanium, silver, or nickel, and the total content of these metals is the metal impurity content.

The metal impurity content of the silica particles can be 5 ppm by mass or less by obtaining silica particles by performing a hydrolysis reaction and a condensation reaction using alkoxysilane as a main raw material.

In the method by deionization of alkali silicate such as water glass, sodium or the like derived from the raw material remains, and thus it is extremely difficult to set the metal impurity content of the silica particles to 5 ppm by mass or less.

The average primary particle diameter of the silica particles according to the present embodiment is preferably 15 nm to 700 nm, more preferably 30 nm to 400 nm, and still more preferably 45 nm to 250 nm. When the average primary particle diameter of the silica particles is 15 nm or more, the storage stability of the silica sol is excellent. In addition, when the average primary particle diameter of the silica particles is 700 nm or less, the surface roughness and scratches of the object to be polished, such as a silicon wafer, can be reduced, and sedimentation of the silica particles can be suppressed.

The average primary particle diameter of the silica particles is measured by a BET method. Specifically, the specific surface area of the silica particles is measured using a specific surface area automatic measuring device, and the average primary particle diameter is calculated using the following formula (2): $\begin{matrix}average primary particle diameter \left(nm\right) \\ = 6000 / \left(specific surface area \left({m}^{2}/g\right)\times density \left({g / cm}^{3}\right)\right.\end{matrix}$ (2).

The average primary particle diameter of the silica particles can be set to a desired range depending on the production conditions of the silica particles.

The average secondary particle diameter of the silica particles according to the present embodiment corresponds to x (nm) in the above formula (1b) and exceeds 50 nm.
The average secondary particle diameter of the silica particles is preferably 55 nm to 1000 nm, more preferably 65 nm to 500 nm, still more preferably 75 nm to 400 nm, and particularly preferably 100 nm to 300 nm. When the average secondary particle diameter of the silica particles is 55 nm or more, the polishing rate of the silica particles is excellent. In addition, when the average secondary particle diameter of the silica particles is 1000 nm or less, the surface roughness and scratches of the object to be polished, such as a silicon wafer during polishing, can be reduced, the removability of particles and the like in cleaning after polishing is excellent, and sedimentation of the silica particles can be suppressed.

The average secondary particle diameter of the silica particles is measured by DLS method. Specifically, the measurement is performed using a dynamic light scattering particle diameter measurement device.

The average secondary particle diameter of the silica particles can be set to a desired range depending on the production conditions of the silica particles. For example, the average secondary particle diameter of the silica particles tends to increase when the reaction temperature of the hydrolysis and condensation reaction of the tetraalkoxysilane is low, and the average secondary particle diameter of the silica particles tends to decrease when the reaction temperature of the hydrolysis and condensation reaction of the tetraalkoxysilane is high. As described later, when a salt is added to the reaction system, the average secondary particle diameter of the silica particles tends to increase.

The cv value of the silica particles according to the present embodiment is preferably 10% to 50%, more preferably 15% to 40%, and still more preferably 20% to 30%. When the cv value of the silica particles is 10% or more, the polishing rate with respect to the object to be polished, such as a silicon wafer, is excellent, and the productivity of the silicon wafer is excellent. In addition, when the cv value of the silica particles is 50% or less, the surface roughness and scratches of the polished object represented by the silicon wafer at the time of polishing can be reduced, and the removability of particles and the like in cleaning after polishing is excellent.

The average secondary particle diameter of the silica particles is measured by using a dynamic light scattering particle diameter measuring device, and the cv value of the silica particles is calculated using the following formula (3): $cv value = \left(standard deviation \left(nm\right)/average secondary particle diameter \left(nm\right)\times 100\right)$ (3).

The association ratio of the silica particles according to the present embodiment is preferably 1.1 to 3.5, more preferably 1.3 to 3.0, and still more preferably 1.4 to 2.5. When the association ratio of the silica particles is 1.1 or more, the polishing rate with respect to the object to be polished, such as a silicon wafer, is excellent, and the productivity of the silicon wafer is excellent. In addition, when the association ratio of the silica particles is 3.5 or less, the surface roughness and scratches of the object to be polished, such as a silicon wafer during polishing, can be reduced, and aggregation of the silica particles can be suppressed.

The association ratio of the silica particles is calculated from the average primary particle diameter measured by the above-described measurement method and the average secondary particle diameter measured by the above-described measurement method using the following formula (4): $association ratio = average secondary particle diameter / average primary particle diameter$ (4).

The ratio of the long diameter/the short diameter of the silica particles according to the present embodiment is preferably 1.01 to 1.39, more preferably 1.06 to 1.25, and still more preferably 1.09 to 1.18. When the ratio of the major axis to the minor axis is 1.01 or more, a frictional force is applied between the silica particles and the object to be polished by the rotation of the silica particles during polishing, and thus the polishing rate is excellent.
In addition, when the ratio of the long diameter/the short diameter is 1.39 or less, the silica particles are prevented from periodically overly coming into contact with the polishing target due to the rotation of the silica particles at the time of polishing, and thus the polishing is excellent in that the polishing proceeds to be flat.

The ratio of the long diameter/the short diameter of the silica particles is calculated by observing the silica particles with a scanning electron microscope, calculating the average long diameter and the average short diameter of the silica particles, and dividing the average long diameter by the average short diameter. Regarding the average long diameter and the average short diameter, the long diameter and the short diameter are determined for 100 or more silica particles, respectively, and the average value thereof is used. Here, the long diameter is the long side of the quadrangle circumscribing the electron microscope image of the particle having the smallest area, and the short diameter is the short side of the quadrangle circumscribing the electron microscope image of the particles having the smallest area.

The number of fine particles contained in the silica particles according to the present embodiment is preferably 10 or less per 100 main particles, more preferably 5 or less per 100 main particles, even more preferably 1 or less per 100 main particles, and particularly preferably not detected. The fine particles refer to particles having the long diameter of 20 nm or less, the main particles refer to particles having the long diameter falling within the range of the average long diameter ± 50%, and the number of fine particles and the main particles can be counted by observing the silica particles with a scanning electron microscope.
When the number of fine particles contained in the silica particles is 10 or less per 100 main particles, the silica particles adhering to the object to be polished after polishing can be easily washed and removed.

The number of fine particles contained in the silica particles can be set to a desired range depending on the production conditions of the silica particles. For example, when the reaction temperature of the hydrolysis and condensation reaction of the tetraalkoxysilane is high, the number of fine particles decreases.

The silica particles according to the present embodiment preferably contain an alkoxysilane condensate as a main component, more preferably contain a tetraalkoxysilane condensate as a main component, and even more preferably contain a tetramethoxysilane condensate as a main component, because the content of metal impurities is small and the silica particles have appropriate mechanical strength and flexibility due to a trace amount of residual alkoxy groups inside the particles. The main component refers to a component that accounts for 50% by mass or more based on 100% by mass of all components constituting the silica particles.

In order to obtain silica particles containing an alkoxysilane condensate as a main component, an alkoxysilane is preferably used as a main raw material. In order to obtain silica particles containing a tetraalkoxysilane condensate as a main component, tetraalkoxysilane is preferably used as a main raw material. In order to obtain silica particles containing a tetramethoxysilane condensate as a main component, tetramethoxysilane is preferably used as a main raw material. The main raw material refers to a raw material that is 50% by mass or more based on 100% by mass of all raw materials constituting the silica particles.

An amount of silanol groups in the silica particles according to the present embodiment is preferably 0.4 wt% to 2.5 wt%, more preferably 1.15 wt% to 1.55 wt%, and still more preferably 1.2 wt% to 1.45 wt% with respect to the weight of the silica particles.
When the amount of silanol groups in the silica particles is 0.4 wt% or more, the silica particles have an appropriate surface repulsion due to the charge generated by ionization of the silanol group and the layer of water hydrated to the silanol group, and the dispersion stability of the silica sol is excellent. When the amount of silanol groups in the silica particles is 2.5 wt% or less, the repulsion between the silica particles and the object to be polished by hydration water is appropriately suppressed, and the polishing rate is excellent.

The amount of the silanol group in the silica particles is measured by a shear method. Specifically, measurement and calculation are performed under the following conditions.

Silica sol corresponding to 1.5 g of silica particles is collected, pure water is added, and the solution amount is adjusted to 90 mL. Under an environment of 25°C, 0.1 mol/L of an aqueous solution of hydrochloric acid is added until the pH reaches 3.6, 30 g of sodium chloride is added, sodium chloride is completely dissolved while gradually adding pure water, and pure water is finally added until the total amount of a test solution reaches 150 mL to obtain a test solution.

The obtained test solution is placed in an automatic titrator, 0.1 mol/L of an aqueous solution of sodium hydroxide is added dropwise, and a titration amount A (mL) regarding 0.1 mol/L of the aqueous solution of sodium hydroxide required for the pH to change from 4.0 to 9.0 is measured.

A consumption amount V (mL) of 0.1 mol/L of the aqueous solution of sodium hydroxide required for pH of 4.0 to 9.0 per 1.5 g of silica particles is calculated using the following formula (5), and the mass ratio of the silanol group is calculated using the following formula (6). The mass ratio of the silanol group calculated in this manner is also referred to herein as the silanol group amount of the silica particles. $V = \left(A\times f\times 100\times 1.5\right) / \left(W\times C\right)$ (5)
A: titration amount (mL) of 0.1 mol/L of an aqueous solution of sodium hydroxide required for pH of 4.0 to 9.0 per 1.5 g of silica particles
f: titer of 0.1 mol/L of the aqueous solution of sodium hydroxide used
C: concentration of silica particles in silica sol (% by mass)
W: amount of collected silica sol (g) $s = \left(B\times {w}_{OH}\right) / M \times 100$ (6)
B: amount of sodium hydroxide (mol) required for pH of 4.0 to 9.0 per 1.5 g of silica particles calculated from V
w_{OH}: formula weight of silanol group (17 g/mol)
M: amount of silica particles (1.5 g)
s: mass ratio of silanol groups in silica particles

An amine content of the silica particles according to the present embodiment is preferably less than 5 µmol/g, more preferably less than 3 µmol/g, and still more preferably less than 1 µmol/g. When the amine content of the silica particles is less than 5 µmol/g, corrosion of an object to be polished and equipment used for polishing can be avoided when the silica particles are used for polishing, which is preferable.

The lower limit of the amine content of the silica particles is not particularly limited, and may be, for example, 0.001 µmol/g or more.
Alternatively, the content can be reduced to zero by not using an amine in the production of silica particles.

The amine refers to primary amine, secondary amine, and tertiary amine and is specifically represented by the following general formula (X).

### NRaRbRc (X)

(In the formula, Ra, Rb, and Rc represent an optionally substituted alkyl group having 1 to 12 carbon atoms or a hydrogen atom. However, not all of Ra, Rb, and Rc are hydrogen atoms, that is, ammonia is excluded from the amine represented by the general formula (X).

Ra, Rb, and Rc may be the same as or different from each other. When Ra, Rb and Rc are alkyl groups, they may be linear, branched or cyclic alkyl groups. When Ra, Rb, and Rc are substituted alkyl groups, examples of the substituent include an alkoxy group, an amino group, a primary amino group substituted with an alkyl group, an amino group disubstituted with an alkyl group, and a hydroxy group.)

The amine content of the silica particles is measured by ion chromatography analysis. Specifically, silica particles are separated from other components by centrifugation or the like, silica is dissolved by a sodium hydroxide aqueous solution or the like, and the amine in the solution is quantified by ion chromatography.

### [Method for Producing Silica Particles]

The silica particles according to the present embodiment can be produced by a production method including a step of subjecting an alkoxysilane to hydrolysis and condensation reaction in a solution containing a salt. Silica particles satisfying the above formulae (1a) and (1b) can be obtained by a production method including such a step. The reason for this is not clear, but it is considered that when the silica particles are grown in a state where a salt is dissolved in a solution and ionic strength is increased, the repulsion due to the surface charge between the silica particles is weakened and aggregation is promoted, and thus the particle diameter is increased while the true specific gravity of the particles is kept large.

Examples thereof include ammonium acetate, ammonium tartrate, ammonium citrate, ammonium acetate, ammonium benzoate, ammonium malate, ammonium butyrate, ammonium propionate, ammonium oxalate, ammonium maleate, ammonium citrate, ammonium glutarate, ammonium fumarate, ammonium oxalate, ammonium sorbate, ammonium palmitate, ammonium laurate, ammonium sebacate, ammonium pimaric acid, ammonium stearate, sodium acetate, ammonium acetate, sodium carbonate, sodium hydrogen phosphate, ammonium hydrogen phosphate, sodium dihydrogen phosphate, ammonium dihydrogen phosphate, sodium citrate, ammonium citrate, ammonium nitrate, ammonium chloride, sodium sulfate, ammonium sulfate, sodium borate, ammonium borate, sodium butyrate, ammonium butyrate, sodium propionate, ammonium carbamate, ammonium sulfamate, ammonium lactate, ammonium oxalate, tetramethoxyammonium acetate, tetraethoxyammonium acetate, tetrapropoxyammonium acetate, tetrabutoxyammonium acetate, ammonium trifluoroacetate, tetramethoxyammonium benzoate, tetraethoxyammonium benzoate, tetrapropoxyammonium benzoate, tetrabutoxyammonium benzoate, tetraethylammonium hydrogencarbonate, ammonium carbonate, sodium hydrogen carbonate, and the like. These salts may be used alone or in combination of two or more thereof. The salt is preferably a neutral salt, that is, a salt of a weak acid and a weak base or a salt of a strong acid and a strong base because the reaction rate of the tetraalkoxysilane is not changed by suppressing a change in the pH of the reaction solution by addition. In addition, as the salt, it is possible to avoid contamination of the finally obtained silica particles and silica sol, and since the industrial application range of the silica particles and the silica sol is widened, a salt which decomposes or volatilizes when heated to 100°C is preferable. These salts need not be completely decomposed or volatilized at the time when the temperature reaches 100°C, and decomposition or volatilization may be started at 100°C.

Specifically, as the salt, ammonium carbamate, ammonium carbonate, and ammonium bicarbonate are preferable, and ammonium bicarbonate is more preferable.

In the method for producing silica particles according to the present embodiment, the alkoxysilane is preferably subjected to hydrolysis and condensation reaction using an alkali catalyst. The reason why it is preferable to use an alkali catalyst and a preferred embodiment thereof are as described for a solution (A) and a solution (C) described later.

In the step of hydrolyzing and condensing the alkoxysilane in the solution containing the salt, a molar ratio of an amount of the salt to an amount of the alkali catalyst contained in the solution at the start of the reaction is not particularly limited, but is preferably 1.0×10⁻⁴ to 4.5×10⁻², more preferably 1.0×10⁻³ to 3.0×10⁻², still more preferably 2.5×10⁻³ to 2.0×10⁻², and particularly preferably 4.5×10⁻³ to 1.0×10⁻². The molar ratio is determined in detail by the following formula. $\begin{matrix}\left(Molar Ratio\right) \\ = \left(amount of salt used \left(mol\right)\right) / \left(amount of alkali catalyst used \left(mol\right)\right)\end{matrix}$

When the molar ratio is 1.0×10⁻⁴ or more, the particle diameter can be effectively adjusted to be large. When the content is 4.5×10⁻² or less, aggregation and precipitation of the silica particles can be suppressed.

Furthermore, since the hydrolysis reaction and the condensation reaction are easily controlled, the reaction rate of the hydrolysis reaction and the condensation reaction can be increased, the gelation of the dispersion of the silica particles can be prevented, and the silica particles having the uniform particle diameter can be obtained, the method for producing the silica particles according to the present embodiment preferably includes a step of adding a solution (B) containing tetraalkoxysilane and, as necessary, a solution (C) to a solution (A) containing water, and subjecting the tetraalkoxysilane to a hydrolysis reaction and a condensation reaction.

Since the purpose is to promote the aggregation of the particles generated in the early stage of the reaction, when the solution (A), the solution (B), and the solution (C) as necessary are used in the method for producing silica particles according to the present embodiment, the salt is preferably contained in the solution (A).

The solution (A) contains water.

Since the solution (A) has excellent dispersibility in the reaction solution of tetraalkoxysilane, the solution (A) preferably contains a solvent other than water.

Examples of the solvent other than water in the solution (A) include methanol, ethanol, propanol, isopropanol, ethylene glycol, and the like.
These solvents may be used alone or in combination of two or more thereof. Among these solvents, because tetraalkoxysilane is easily dissolved, and those used in the hydrolysis reaction and the condensation reaction are the same as those produced as a by-product and manufacturing convenience is excellent, alcohols are preferable, methanol and ethanol are more preferable, and methanol is still more preferable.

The solution (A) preferably contains an alkali catalyst because the reaction rate of the hydrolysis reaction and condensation reaction of the tetraalkoxysilane can be increased.

Examples of the alkali catalyst in the solution (A) include ethylenediamine, diethylenetriamine, triethylenetetramine, ammonia, urea, ethanolamine, tetramethylammonium hydroxide, and the like. These alkali catalysts may be used alone or in combination of two or more thereof. Among these alkali catalysts, ammonia is preferable because it is excellent in catalytic action, can easily control the particle shape, can suppress mixing of metal impurities, and has high volatility and excellent removability after hydrolysis reaction and condensation reaction.

The concentration of water in the solution (A) is preferably 3% by mass to 90% by mass, and more preferably 5% by mass to 50% by mass, based on 100% by mass of the solution (A). When the concentration of water in the solution (A) is 3% by mass or more, the hydrolysis reaction rate of the tetraalkoxysilane is easily controlled. When the concentration of water in the solution (A) is 90% by mass or less, the reaction balance between the hydrolysis reaction and the condensation reaction is good, and the particle shape is easily controlled.

A concentration of the alkali catalyst in the solution (A) is preferably 0.5% by mass to 3.0% by mass and more preferably 1.3% by mass to 2.5% by mass based on 100% by mass of the solution (A). When the concentration of the alkali catalyst in the solution (A) is 0.5% by mass or more, aggregation of the silica particles is suppressed, and the dispersion stability of the silica particles in the dispersion is excellent. When the concentration of the alkali catalyst in the solution (A) is 3.0% by mass or less, the reaction does not proceed excessively fast, and the reaction controllability is excellent. This is also excellent in that the alkali catalyst is easily removed by evaporation in step (1) described later.

When the solution (A) contains a solvent other than water, the concentration of the solvent other than water is preferably the balance of the water, the alkali catalyst, and the salt described above.

The solution (B) contains tetraalkoxysilane.

Examples of the tetraalkoxysilane in the solution (B) include tetramethoxysilane, tetraethoxysilane, tetrapropoxysilane, tetraisopropoxysilane, and the like. These tetraalkoxysilanes may be used alone or in combination of two or more thereof. Among these tetraalkoxysilanes, tetramethoxysilane and tetraethoxysilane are preferable, and tetramethoxysilane is more preferable, since hydrolysis reaction is fast, unreacted substances hardly remain, productivity is excellent, and stable silica sol can be easily obtained.

As the raw material of the silica particles, raw materials other than tetraalkoxysilane such as a low condensate of tetraalkoxysilane may be used, but since the reactivity is excellent, it is preferable that the tetraalkoxysilane is 50 mass% or more, the raw material other than the tetraalkoxysilane is less than 50 mass%, and more preferable that the tetraalkoxysilane is 90 mass% or more, and the raw material other than the tetraalkoxysilane is less than 10 mass%, based on 100 mass% of all raw materials constituting the silica particles.

The solution (B) may contain only tetraalkoxysilane without containing a solvent, but preferably contains a solvent because it is excellent in dispersibility of tetraalkoxysilane in the reaction solution.

Examples of the solvent in the solution (B) include methanol, ethanol, propanol, isopropanol, ethylene glycol, and the like. These solvents may be used alone or in combination of two or more thereof. Among these solvents, because those used in the hydrolysis reaction and the condensation reaction are the same as those produced as a by-product and manufacturing convenience is excellent, alcohols are preferable, methanol and ethanol are more preferable, and methanol is still more preferable.

The concentration of the tetraalkoxysilane in the solution (B) is preferably 60% by mass to 95% by mass, and more preferably 70% by mass to 90% by mass, based on 100% by mass of the solution (B). When the concentration of the tetraalkoxysilane in the solution (B) is 60% by mass or more, the reaction solution tends to be uniform. In addition, when the concentration of tetraalkoxysilane in the solution (B) is 95% by mass or less, formation of a gel-like material can be suppressed.

A concentration of the solvent in the solution (B) is preferably 5% by mass to 40% by mass, and more preferably 10% by mass to 30% by mass, based on 100% by mass of the solution (B). When the concentration of the solvent of the solution (B) is 5% by mass or more, formation of a gel-like material can be suppressed. When the concentration of the solvent of the solution (B) is 40% by mass or less, the reaction solution tends to be uniform.

An addition rate of the solution (B) per unit time to the volume of the solution (A) is preferably 0.02 kg/hour/L to 1.3 kg/hour/L, and more preferably 0.05 kg/hour/L to 0.8 kg/hour/L. When the addition rate of the solution (B) is 0.02 kg/hour/L or more, the productivity of the silica particles is excellent. In addition, when the addition rate of the solution (B) is 1.3 kg/hour/L or less, formation of a gel-like substance can be suppressed.

A ratio of the volume of the solution (B) to the volume of the solution (A) is preferably 0.120 to 4.00, and more preferably 0.400 to 1.50. When the ratio is 0.120 or more, the concentration of silica contained in the solution obtained after the reaction is high and the yield is excellent. When the ratio is 4.00 or less, the concentration of the silica particles in the reaction solution is appropriately low, and the dispersibility of the silica particles is excellent.

The solution (C) is a solution containing water, and preferably further contains an alkali catalyst.

Examples of the alkali catalyst that can be contained in the solution (C) include ethylenediamine, diethylenetriamine, triethylenetetramine, ammonia, urea, ethanolamine, tetramethylammonium hydroxide, and the like. These alkali catalysts may be used alone or in combination of two or more thereof. Among these alkali catalysts, ammonia is preferable because it is excellent in catalytic action, can easily control the particle shape, can suppress mixing of metal impurities, and has high volatility and excellent removability after hydrolysis reaction and condensation reaction.

The solution (C) contains water as a solvent, and examples of the solvent other than water include methanol, ethanol, propanol, isopropanol, ethylene glycol, and the like. As the solvent other than water, one type may be used alone, or two or more types may be used in combination. Among the solvents of the solution (C), because those used in the hydrolysis reaction and the condensation reaction are the same as those produced as a by-product and manufacturing convenience is excellent, water or a combination of water and an alcohol is preferable, and only water is more preferable.

A concentration of the alkali catalyst in the solution (C) is preferably 0% by mass to 10% by mass based on 100% by mass of the solution (C). The concentration of the alkali catalyst in the solution (C) may be 0% by mass, that is, not included, but is preferably 0.5% by mass or more, more preferably 3% by mass or more, and still more preferably 4% by mass or more when the alkali catalyst is contained. When the concentration of the alkali catalyst in the solution (C) is 0.5% by mass or more, the concentration of the alkali catalyst in the reaction solution can be easily adjusted from the start of the reaction to the end of the reaction. From the viewpoint of reducing the variation in the concentration of the alkali catalyst in the reaction solution, the concentration of the alkali catalyst in the solution (C) is preferably 10% by mass or less, and more preferably 7% by mass or less.

A concentration of water in the solution (C) is preferably 90% by mass to 100% by mass based on 100% by mass of the solution (C). The concentration of water in the solution (C) may be 100 mass%, that is, the solution (C) may be composed only of water, but when other components are contained, the concentration of water is preferably 99.5 mass% or less, more preferably 99 mass% or less. From the viewpoint of reducing the variation in the concentration of the alkali catalyst in the reaction solution, the concentration of water in the solution (C) is preferably 90% by mass or more, and more preferably 94% by mass or more.
When the concentration of water in the solution (C) is 99.5 mass% or less, the concentration of the alkali catalyst in the reaction solution can be easily adjusted from the start of the reaction to the end of the reaction.

The concentration of the solvent other than water in the solution (C) is preferably the concentration of the balance of the water or the balance of the water and the alkali catalyst.

The addition of the solution (B) or the solution (B) and the solution (C) is preferably performed into the solution of the solution (A). When the solution (B) or the solution (B) and the solution (C) are added into the solution of the solution (A), the mixability of each component in the reaction solution is enhanced, the abnormal reaction in the air can be suppressed, and the particle shape can be easily controlled, in the case where an alkali catalyst having high volatility represented by ammonia is desired to be used and where the hydrolysis reaction and the condensation reaction are desired to proceed at a high reaction temperature. The term "added into the solution" means adding the solution equal to or below the liquid surface, and the solution (B) or the solution (B) and the solution (C) can be added into the solution of the solution (A) by setting the supply outlet of the solution (B) or the supply outlet of the solution (B) and the supply outlet of the solution (C) to be equal to or lower than the liquid surface of the solution (A).

When the solution (B) and the solution (C) are added, the timing of adding the solution (B) to the solution (A) and the timing of adding the solution (C) may be the same or may be different from each other, but are preferably the same because the variation in the reaction composition is small and the operation is not complicated.

The pH in the step of hydrolyzing and condensing tetraalkoxysilane is 8.0 to 14, preferably 8.2 to 13, and more preferably 8.5 to 12. When the pH in the step is 8.0 or more, the reaction rate of the hydrolysis reaction and the condensation reaction is excellent, and aggregation of the silica particles can be suppressed. When the pH in the step is 14 or less, the shape of the silica particles is easily controlled, and the smoothness of the surface of the silica particles is excellent.

The method for producing silica particles according to the present embodiment preferably includes a step of performing a hydrolysis reaction and a condensation reaction of an alkoxysilane at 40°C or higher, and more preferably a step of performing a hydrolysis reaction and a condensation reaction at 46°C or higher. When the reaction temperature is 40°C or higher, the reaction rate of the hydrolysis reaction and condensation reaction of the alkoxysilane is appropriately improved, and the four bonds of silicon atoms can form a siloxane bond before the particle growth proceeds. As a result, fine pores present in the particles can be reduced. As a result, the true specific gravity of the particles can be increased, which is preferable. The reaction temperature is preferably less than 70°C, more preferably 60°C or less, and still more preferably 50°C or less. When the reaction temperature is less than 70°C, the balance between the hydrolysis reaction rate and the condensation reaction rate is excellent.

The concentration of water in the reaction system of the hydrolysis reaction and the condensation reaction is preferably maintained at 3% by mass to 90% by mass, more preferably maintained at 5% by mass to 30% by mass, and still more preferably maintained at 6% by mass to 25% by mass, based on 100% by mass of the total amount in the reaction system. When the concentration of water in the reaction system is 3% by mass or more, the hydrolysis reaction rate of the tetraalkoxysilane is easily controlled. When the concentration of water in the reaction system is 90% by mass or less, the reaction balance between the hydrolysis reaction and the condensation reaction is good, and the particle shape is easily controlled.

The concentration of the alkali catalyst in the reaction system of the hydrolysis reaction and the condensation reaction is preferably 0.5% by mass to 3.0% by mass, and more preferably 1.3% by mass to 2.5% by mass, based on 100% by mass of the total amount in the reaction system. When the concentration of the alkali catalyst in the reaction system is 0.5% by mass or more, aggregation of the silica particles is suppressed, and the dispersion stability of the silica particles in the dispersion is excellent. When the concentration of the alkali catalyst in the reaction system is 3.0% by mass or less, the reaction does not proceed excessively fast, and the reaction controllability is excellent.

The concentration of the silica particles in the dispersion of the silica particles obtained by the step of hydrolyzing and condensing the alkoxysilane is preferably 5.0% by mass to 30.0% by mass, and more preferably 12.0% by mass to 20% by mass. When the concentration of the silica particles in the dispersion of the silica particles is 5.0% by mass or more, the yield of the silica particles is excellent. When the concentration of the silica particles in the dispersion of the silica particles is 30.0% by mass or less, the dispersibility of the silica particles is excellent.

Since the method for producing silica particles according to the present embodiment can remove unnecessary components and add necessary components, the method preferably further includes the following step (1).

Step (1): a step of removing the dispersion medium of the dispersion of the obtained silica particles and adding a dispersion medium to the dispersion of the silica particles.

Any of the removal of the dispersion medium of the dispersion of the silica particles and the addition of the dispersion medium in the step (1) may be performed first or they are performed simultaneously. When only concentration of the dispersion medium is performed, the dispersion of the silica particles is concentrated.

The method of concentrating the dispersion of the silica particles is not particularly limited, and examples thereof include a heating concentration method and a membrane concentration method.

In order to concentrate the dispersion of the silica particles by the heat concentration method, the dispersion may be heated and concentrated under normal pressure or under reduced pressure.

In order to concentrate the dispersion of silica particles by the membrane concentration method, membrane separation by ultrafiltration is preferred. The main purpose of the ultrafiltration method is to remove unnecessary components such as an intermediate product. The molecular weight cut-off of the ultrafiltration membrane used here is selected such that the intermediate product can be filtered and separated and removed in accordance with the intermediate product in the dispersion.

Examples of the material of the ultrafiltration membrane include polysulfone, polyacrylonitrile, sintered metal, ceramic, carbon, and the like. Examples of the form of the ultrafiltration membrane include a spiral type, a tubular type, a hollow fiber type, and the like.

Examples of the dispersion medium to be added to the dispersion of the silica particles include water, methanol, ethanol, propanol, isopropanol, ethylene glycol, and the like. These dispersion media may be used alone or in combination of two or more thereof.
Among these dispersion media, water and alcohol are preferable and water is more preferable because of excellent affinity with silica particles.

When the dispersion medium is removed and the dispersion medium is simultaneously added to the dispersion of the silica particles, the dispersion medium is replaced. **In** this case, it is preferable that the dispersion medium can be replaced without significantly changing the amount of the silica particles contained in the dispersion of the silica particles per unit volume.

The method for producing silica particles according to the present embodiment preferably further includes the following step (2) because the degree of condensation of the silica particles can be increased.

Step (2): a step of pressurizing and heating the dispersion of the silica particles obtained in the step (1).

The pressure of the pressurized heat treatment is preferably 0.10 MPa to 2.3 MPa, and more preferably 0.12 MPa to 2.0 MPa. When the pressure in the pressurization and heating treatment is 0.10 MPa or more, the degree of condensation of the silica particles can be increased. When the pressure in the pressurization and heating treatment is 2.3 MPa or less, silica particles can be produced without greatly changing the average primary particle diameter, the average secondary particle diameter, the cv value, and the association ratio, and the dispersion stability of the silica sol is excellent.

The dispersion of the silica particles may be heated to a temperature equal to or higher than the boiling point of the dispersion medium in a sealed state. When the aqueous dispersion of the silica particles is heated to 100°C or higher in a sealed state, the pressure becomes the saturated vapor pressure of the temperature.

The temperature of the pressurized heat treatment is preferably 100°C to 220°C, and more preferably 110°C to 180°C. When the temperature of the pressure heating treatment is 100°C or higher, the degree of condensation of the silica particles can be increased. When the temperature of the pressurization and heating treatment is 220°C or less, silica particles can be produced without greatly changing the average primary particle diameter, the average secondary particle diameter, the cv value, and the association ratio, and the dispersion stability of the silica sol is excellent.

The time of the pressure heating treatment is preferably 0.25 hours to 10 hours, and more preferably 0.5 hours to 8 hours. When the time of the pressure heating treatment is 0.25 hours or more, the degree of condensation of the silica particles can be increased. When the time of the pressurization and heating treatment is 10 hours or less, silica particles can be produced without greatly changing the average primary particle diameter, the average secondary particle diameter, the cv value, and the association ratio, and the dispersion stability of the silica sol is excellent.

Since the condensation degree of the silica particles can be increased without greatly changing the average primary particle diameter, the average secondary particle diameter, the cv value, and the association ratio, the pressure heating treatment is more preferably performed in an aqueous dispersion.

The pH of the pressurized heat treatment in the aqueous dispersion is preferably 6.0 to 8.0, and more preferably 6.5 to 7.8. When the pH of the pressurized heat treatment in the aqueous dispersion is 6.0 or more, gelation of the silica sol can be suppressed. When the pH is 8.0 or less during the pressurized heat treatment performed in the aqueous dispersion, the degree of condensation of the silica particles can be increased without significantly changing the average primary particle diameter, the average secondary particle diameter, the cv value, and the association ratio.

### [Silica Sol]

The silica sol according to the present embodiment includes the silica particles according to the present embodiment.

The silica sol may be produced by using the dispersion of the silica particles according to the present embodiment as it is, or by removing unnecessary components and adding necessary components among the components in the dispersion of the silica particles according to the present embodiment.

The silica sol according to the present embodiment preferably contains silica particles and a dispersion medium.

Examples of the dispersion medium in the silica sol include water, methanol, ethanol, propanol, isopropanol, ethylene glycol, and the like. These dispersion media in the silica sol may be used alone or in combination of two or more thereof. Among these dispersion media in the silica sol, water and alcohol are preferable, and water is more preferable because of excellent affinity with silica particles.

A content of the silica particles in the silica sol is preferably 3% by mass to 50% by mass, more preferably 4% by mass to 40% by mass, and still more preferably 5% by mass to 30% by mass with respect to 100% by mass of the total amount of the silica sol. When the content of the silica particles in the silica sol is 3% by mass or more, the polishing rate with respect to the object to be polished, such as a silicon wafer, is excellent. When the content of the silica particles in the silica sol is 50% by mass or less, aggregation of the silica particles in the silica sol or the polishing composition can be suppressed, and the storage stability of the silica sol or the polishing composition is excellent.

A content of the dispersion medium in the silica sol is preferably 50% by mass to 97% by mass, more preferably 60% by mass to 96% by mass, and still more preferably 70% by mass to 95% by mass with respect to 100% by mass of the total amount of the silica sol. When the content of the dispersion medium in the silica sol is 50% by mass or more, aggregation of silica particles in the silica sol or the polishing composition can be suppressed, and the storage stability of the silica sol or the polishing composition is excellent. When the content of the dispersion medium in the silica sol is 97 mass% or less, the polishing rate with respect to the object to be polished, such as a silicon wafer, is excellent.

A content of the basic substance in the silica sol is preferably 1 ppm to 1000 ppm, more preferably 10 ppm to 500 ppm, still more preferably 45 ppm to 150 ppm, and particularly preferably 50 ppm to 100 ppm per weight of the silica sol. When the content of the basic substance in the silica sol is 1 ppm or more, the pH of the silica sol can be appropriately maintained near neutrality, and thus the storage stability is excellent. In addition, when the content of the basic substance in the silica sol is 1000 ppm or less, it is preferable in terms of avoiding corrosion of an object to be polished and equipment used for polishing when the silica sol is used for polishing. In addition, it is preferable to adjust the pH when adjusting the polishing composition using the silica sol. Here, the basic substance is a generic term for substances exhibiting basicity such as a nitrogen basic substance such as ammonia or amine, and an inorganic hydroxide.

The content of the basic substance in the silica sol can be adjusted by appropriately selecting the type of the alkali catalyst used in the step of producing the silica particles and then appropriately removing the selected type. When ammonia is used as the alkali catalyst, the ammonia content in the silica sol can be appropriately reduced by appropriately lengthening the removal of the dispersion medium in the step (1) described above. At this time, it is preferable to remove the dispersion medium by heating the dispersion of the silica particles in order to improve the efficiency of removing ammonia.

The method for measuring the content of the basic substance in the silica sol may be selected depending on the type of the basic substance to be treated. For example, in the case of amine, amine can be quantified by measuring a liquid obtained by dissolving silica particles by adding sodium hydroxide to silica sol by ion chromatography. In addition, in the case of ammonia, sodium hydroxide is added to the silica sol, ammonia is completely desorbed from the silica particles in the form of ammonia molecule (NH₃), and is measured with the ammonia electrode to quantify the content of ammonia in the silica sol.

The content of the silica particles and the dispersion medium in the silica sol can be set to a desired range by removing unnecessary components among the components in the dispersion of the obtained silica particles and adding necessary components.

In addition to the silica particles and the dispersion medium, the silica sol may contain other components such as an oxidizing agent, a preservative, an antifungal agent, a pH adjusting agent, a pH buffer, a surfactant, a chelating agent, and an antibacterial biocide, as necessary, as long as the performance thereof is not impaired.

In particular, since the storage stability of the silica sol is excellent, it is preferable that the silica sol contain an antibacterial biocide.

Examples of the antimicrobial biocide include hydrogen peroxide, ammonia, quaternary ammonium hydroxide, quaternary ammonium salt, ethylenediamine, glutaraldehyde, methyl p-hydroxybenzoate, sodium chlorite, and the like. These antimicrobial biocides may be used alone or in combination of two or more. Among these antibacterial biocides, hydrogen peroxide is preferable because of excellent affinity with silica sol.

The antibacterial biocides generally include those called bactericides.

The content of the antimicrobial biocide in the silica sol is preferably 0.0001% by mass to 10% by mass, and more preferably 0.001% by mass to 1% by mass, based on 100% by mass of the total amount of the silica sol. When the content of the antimicrobial biocide in the silica sol is 0.0001% by mass or more, the storage stability of the silica sol is excellent. When the content of the antimicrobial biocide in the silica sol is 10% by mass or less, the original performance of the silica sol is not impaired.

The pH of the silica sol is preferably 6.0 to 8.0, and more preferably 6.5 to 7.8. When the pH of the silica sol is 6.0 or more, the dispersion stability is excellent, and aggregation of the silica particles can be suppressed. When the pH of the silica sol is 8.0 or less, dissolution of the silica particles is prevented, and long-term storage stability is excellent.

The pH of the silica sol can be adjusted by setting the content of the basic substance in the silica sol to an appropriate range. In addition, by adding a pH adjuster, a desired range can be set.

### [Polishing Composition]

The polishing composition according to the present embodiment includes the silica sol according to the present embodiment.

The polishing composition according to the present embodiment preferably contains a water-soluble polymer in addition to the silica sol according to the present embodiment.

The water-soluble polymer enhances the wettability of the polishing composition to an object to be polished, such as a silicon wafer. The water-soluble polymer is preferably a polymer having a functional group having a high water affinity, has a high affinity between the functional group having a high water affinity and the silanol group on the surface of the silica particle, and stably disperses the silica particle and the water-soluble polymer in the vicinity of the surface silanol group in the polishing composition. Therefore, when polishing the object to be polished such as a silicon wafer, the effects of the silica particles and the water-soluble polymer synergistically function.

Examples of the water-soluble polymer include a cellulose derivative, polyvinyl alcohol, polyvinylpyrrolidone, a copolymer having a polyvinylpyrrolidone skeleton, a polymer having a polyoxyalkylene structure, and the like.

Examples of the cellulose derivative include hydroxyethyl cellulose, hydroxyethyl cellulose subjected to hydrolysis treatment, hydroxypropyl cellulose, hydroxyethyl methyl cellulose, hydroxypropyl methyl cellulose, methyl cellulose, ethyl cellulose, ethyl hydroxyethyl cellulose, carboxymethyl cellulose, and the like.

Examples of the copolymer having a polyvinylpyrrolidone skeleton include a graft copolymer of polyvinyl alcohol and polyvinylpyrrolidone, and the like.

Examples of the polymer having a polyoxyalkylene structure include polyoxyethylene, polyoxypropylene, copolymers of ethylene oxide and propylene oxide, and the like.

These water-soluble polymers may be used alone or in combination of two or more thereof. Among these water-soluble polymers, cellulose derivatives are preferable, and hydroxyethyl cellulose is more preferable, because they have high affinity with silanol groups on the surface of silica particles and act synergistically to impart good hydrophilicity to the surface of the object to be polished.

A mass average molecular weight of the water-soluble polymer is preferably 1,000 to 3,000,000, more preferably 5,000 to 2,000,000, and still more preferably 10,000 to 1,000,000. When the mass average molecular weight of the water-soluble polymer is 1,000 or more, the hydrophilicity of the polishing composition is improved. In addition, when the mass average molecular weight of the water-soluble polymer is 3,000,000 or less, the affinity with the silica sol is excellent, and the polishing rate with respect to the object to be polished such as the silicon wafer is excellent.

The mass average molecular weight of the water-soluble polymer is measured by size exclusion chromatography under the condition that a 0.1 mol/L NaCl solution in terms of polyethylene oxide is used as a mobile phase.

A content of the water-soluble polymer in the polishing composition is preferably 0.02% by mass to 10% by mass, and more preferably 0.05% by mass to 5% by mass, based on 100% by mass of the total amount of the polishing composition. When the content of the water-soluble polymer in the polishing composition is 0.02% by mass or more, the hydrophilicity of the polishing composition is improved. When the content of the water-soluble polymer in the polishing composition is 10% by mass or less, aggregation of the silica particles during preparation of the polishing composition can be suppressed.

In addition to the silica sol and the water-soluble polymer, the polishing composition according to the present embodiment may contain other components such as a basic compound, a polishing accelerator, a surfactant, a hydrophilic compound, a preservative, an antifungal agent, a pH adjuster, a pH buffer, a surfactant, a chelating agent, and an antibacterial biocide, as necessary, as long as the performance thereof is not impaired.

In particular, since chemical polishing (chemical etching) can be performed by applying a chemical action to the surface of an object to be polished, such as a silicon wafer, and the polishing speed of the object to be polished, such as a silicon wafer, can be improved by the synergistic effect with the silanol group on the surface of the silica particles, the polishing composition preferably contains the basic compound.

Examples of the basic compound include an organic basic compound, an alkali metal hydroxide, an alkali metal hydrogen carbonate, an alkali metal carbonate, ammonia, and the like. These basic compounds may be used alone or in combination of two or more thereof.
Among these basic compounds, ammonia, tetramethylammonium hydroxide, tetraethylammonium hydroxide, ammonium hydrogen carbonate, and ammonium carbonate are preferable, ammonia, tetramethylammonium hydroxide, and tetraethylammonium hydroxide are more preferable, and ammonia is still more preferable, because of their high water solubility and excellent affinity with silica particles and water-soluble polymers.

A content of the basic compound in the polishing composition is preferably 0.001% by mass to 5% by mass, and more preferably 0.01% by mass to 3% by mass, based on 100% by mass of the total amount of the polishing composition. When the content of the basic compound in the polishing composition is 0.001% by mass or more, the polishing rate of the object to be polished, such as a silicon wafer, can be improved. When the content of the basic compound in the polishing composition is 5% by mass or less, the stability of the polishing composition is excellent.

The pH of the polishing composition is preferably 8.0 to 12.0, and more preferably 9.0 to 11.0. When the pH of the polishing composition is 8.0 or more, aggregation of the silica particles in the polishing composition can be suppressed, and the dispersion stability of the polishing composition is excellent. When the pH of the polishing composition is 12.0 or less, the dissolution of the silica particles can be suppressed, and the stability of the polishing composition is excellent.

The pH of the polishing composition can be set to a desired range by adding a pH adjuster.

The polishing composition can be obtained by mixing the silica sol, the water-soluble polymer, and other components as necessary according to the present embodiment, but may be prepared at a high concentration in consideration of storage and transportation, and may be diluted with water or the like immediately before polishing.

### [Polishing Method]

The polishing method according to the present embodiment is a method of polishing using a polishing composition containing the silica sol according to the present embodiment.

As the polishing composition, the polishing composition described above is preferably used.

Specific examples of the polishing method include a method in which the surface of a silicon wafer is pressed against a polishing pad, the polishing composition according to the present embodiment is dropped onto the polishing pad, and the surface of the silicon wafer is polished.

### [Method for Producing Semiconductor wafer]

A method for producing a semiconductor wafer according to the present embodiment is a method including a step of polishing using the polishing composition according to the present embodiment, and a specific polishing composition and a specific polishing method are as described above.

Examples of the semiconductor wafer include a silicon wafer and a compound semiconductor wafer.

### [Method for Producing Semiconductor Device]

A method for producing a semiconductor device according to the present embodiment is a method including a step of polishing using the polishing composition according to the present embodiment, and a specific polishing composition and a specific polishing method are as described above.

### [Application]

The silica particles and the silica sol according to the present embodiment can be suitably used for polishing, and can be used for, for example, polishing of a semiconductor material such as a silicon wafer, polishing of an electronic material such as a hard disk substrate, polishing (chemical mechanical polishing) in a planarization step when producing an integrated circuit, polishing of a synthetic quartz glass substrate used for a photomask or a liquid crystal, polishing of a magnetic disk substrate, and the like, and among them, particularly suitable for polishing of a silicon wafer and chemical mechanical polishing.

Examples of the object to be polished include metals such as Si, Cu, W, Ti, Cr, Co, Zr, Hf, Mo, Ta, Ru, Au, Pt, Ag, Ni, and Al; metal compounds such as oxides, nitrides, and silicides of the above-mentioned metals; intermetallic compounds, glass, resins, and the like. Among these objects to be polished, the silica particles and the silica sol according to the present embodiment can be suitably used for metals and metal oxides, and particularly suitably used for metal oxides.

### [Example]

Hereinafter, the present invention will be more specifically described using examples, but the present invention is not limited to the description of the following examples without departing from the gist thereof.

### (Measurement of Average Secondary Particle Diameter)

The average secondary particle diameter of the silica particles was measured using a dynamic light scattering particle diameter measurement device (Zetasizer Nano ZS produ by Malvern Panalytical Ltd.) for the dispersion of the silica particles obtained in Examples and Comparative Examples.

### (Measurement of True Specific Gravity)

The dispersion of the silica particles obtained in Examples and Comparative Examples was heated and dried, and the true specific gravity was measured by ethanol substitution. 10 g of powdered silica particles obtained by drying were precisely weighed into a glass specific gravity bottle, and further filled with ethanol to fill the specific gravity bottle.
The volume of the filled ethanol was calculated from the difference in the weight of the specific gravity bottle before and after filling ethanol and the specific gravity of ethanol.
Further, the volume of the silica particles was calculated from the difference between the specific gravity bottle volume and the volume of the filled ethanol. The true specific gravity of silica was calculated by dividing the weight of the silica particles by the volume.

### (Measurement of Average Primary Particle Diameter)

The dispersion of the silica particles obtained in Examples and Comparative Examples was dried at 150°C, the specific surface area of the silica particles was measured using a specific surface area automatic measuring device "BELSORP-MR1" (model name, MicrotracBEL Corp.), the density was set to 2.2 g/cm³, and the average primary particle diameter was calculated using the following formula (2): $\begin{matrix}average primary particle demeter \left(nm\right) \\ = 6000 / \left(specific surface area \left({m}^{2}/g\right)\times density \left({g / cm}^{3}\right)\right.\end{matrix}$ (2).

### (Calculation of Association Ratio)

The association ratio of the silica particles obtained in Examples and Comparative Examples was calculated from the average primary particle diameter measured by the above-described measurement method and the average secondary particle diameter measured by the above-described measurement method using the following formula (4): $association ratio = average secondary particle diameter / average primary particle diameter$ (4).

### (Surface Silanol Group Density)

The surface silanol group density of the silica particles contained in the obtained silica sol was determined by a shear method using an automatic titrator (GT-200, manufactured by Nitto Seiko Analytech Co., Ltd.).

Specifically, silica sol corresponding to 1.5 g of silica particles was collected, pure water was added, and the liquid amount was adjusted to 90 mL.
Under an environment of 25°C, an aqueous hydrochloric acid solution of 0.1 mol/L was added until the pH reached 3.6. Then, 30 g of sodium chloride was added, sodium chloride was completely dissolved while gradually adding pure water, and pure water was finally added until the total amount of the test solution reached 150 mL to obtain a test solution.

The obtained test solution was placed in the automatic titrator, and 0.1 mol/L of an aqueous solution of sodium hydroxide was added dropwise to measure a titration amount A(mL) regarding 0.1 mol/L of the aqueous solution of sodium hydroxide required for the pH to change from 4.0 to 9.0.

A consumption amount V (mL) of 0.1 mol/L of the aqueous solution of sodium hydroxide required for pH of 4.0 to 9.0 per 1.5 g of silica particles was calculated using the following formula (5), and the mass ratio s of silanol groups of the silica particles was calculated using the following formula (6).

The results are shown in Table 1.

A consumption amount V (mL) of 0.1 mol/L of the aqueous solution of sodium hydroxide required for pH of 4.0 to 9.0 per 1.5 g of silica particles was calculated using the following formula (5), and the mass ratio of the silanol group was calculated using the following formula (6). $V = \left(A\times f\times 100\times 1.5\right) / \left(W\times C\right)$ (5)
A: titration amount (mL) of 0.1 mol/L of an aqueous solution of sodium hydroxide required for pH of 4.0 to 9.0 per 1.5 g of silica particles
f: titer of 0.1 mol/L of the aqueous solution of sodium hydroxide used
C: concentration of silica particles in silica sol (% by mass)
W: amount of collected silica sol (g) $s = \left(B\times {w}_{OH}\right) / M \times 100$ (6)
B: amount of sodium hydroxide (mol) required for pH of 4.0 to 9.0 per 1.5 g of silica particles calculated from V
w_{OH}: formula weight of silanol group (g/mol)
M: amount of silica particles (1.5 g)
s: mass ratio of silanol groups in silica particles

The average secondary particle diameter of the silica particles was measured by using a dynamic light scattering particle diameter measuring device, and the cv value of the silica particles was calculated using the following formula (3): $cv value = \left(standard deviation \left(nm\right)/average secondary particle diameter \left(nm\right)\times 100\right)$ (3).

### (Average Long Diameter, Average Short Diameter, and Ratio of Long Diameter/Short Diameter of Silica Particles)

The silica sol was diluted about 10000 times with water and 1-propanol, and then dried on a substrate having a flat surface. 100 or more silica particles remaining on the substrate surface were observed with a scanning electron microscope. After the long diameter and the short diameter of each particle were determined, the average value of all the particles observed for each of the long diameter and the short diameter was determined. The obtained average long diameter was divided by the average short diameter to determine the ratio of long diameter/short diameter of the silica particles. Here, the long diameter and the short diameter were each a long side and a short side of a rectangle circumscribing the particle having the smallest area. The magnification at the time of observation with a scanning electron microscope was a magnification such that 10 to 30 particles were contained in one field of view.

### (Number of Fine Particles in Silica Sol)

In the observation of the silica particles with the scanning electron microscope, the presence or absence of particles having a long diameter of less than 20 nm was confirmed.

### (Silica Concentration in Silica Sol)

Approximately 3 g of silica sol was precisely weighed into a glass container, heated to 150°C in an oven, and moisture was evaporated and dried. The mass of the silica particles obtained after drying was accurately measured, and the silica concentration in the silica sol was determined from the difference from the weight before drying.

### (Ammonia Concentration in Silica Sol)

The ammonia concentration in the dispersion of the silica particles was measured by the ammonia selective electrode. Approximately 10 g of silica sol was precisely weighed into a conical flask, and 90 mL of ultrapure water was added thereto and diluted 10 times.
Further, 10 mL of an ion intensity adjusting agent (ISA-NH, manufactured by DKK-TOA CORPORATION) was added to adjust the pH of the liquid to 12 or more. The ammonia selective electrode (AE-2041 manufactured by DKK-TOA CORPORATION) calibrated in advance was inserted in the adjusted liquid, and the ammonia concentration was measured.
The ammonia concentration in the dispersion of the silica particles was converted using the mass of the dispersion of the silica particles and water used for the adjustment.

### (Polishing Rate)

For the silica particles obtained in Examples and Comparative Examples, the polishing rate for a substrate having a metal oxide film on the surface was evaluated by the following index.
A: The polishing rate is assumed to be extremely excellent.
B: The polishing rate is assumed to be excellent.
C: The polishing rate is assumed to be poor.

### [Example 1]

A solution (B) obtained by mixing tetramethoxysilane and methanol at 5.7:1 (mass ratio) and a solution (C) of a 4.2% by mass ammonia aqueous solution were respectively prepared. A solution (A) in which methanol, pure water, and aqueous ammonia were mixed in advance at 16.1:2.2:1 (mass ratio) was charged in a reaction tank equipped with a thermometer, a stirrer, a supply pipe, and a distillation line. The concentration of ammonia in the solution (A) was 2.4% by mass. Further, ammonium hydrogen carbonate was added to the solution (A). The molar ratio of ammonium hydrogen carbonate to ammonia was 0.00125:1.

While maintaining the temperature of the reaction liquid at 50°C, 63.1 parts by volume of the solution (B) and 23.5 parts by volume of the solution (C) were added to 100 parts by volume of the solution (A) at a constant speed over 153 minutes to obtain a dispersion of silica particles. The dispersion of the obtained silica particles was adjusted by adding pure water so that the content of the silica particles was about 20% by mass, and methanol and ammonia were removed by increasing the temperature to obtain a dispersion of silica particles having a silica particle content of about 20% by mass. When the obtained silica particles were observed with a scanning electron microscope, no fine particles were detected.

### [Example 2]

A dispersion of silica particles was obtained in the same manner as in Example 1 except that the molar ratio of ammonium hydrogen carbonate to ammonia in the solution (A) was set to 0.00250:1. When the obtained silica particles were observed with a scanning electron microscope, no fine particles were detected.

### [Example 3]

A solution (B) obtained by mixing tetramethoxysilane and methanol at 5.7:1 (mass ratio) and a solution (C) of a 6.6% by mass ammonia aqueous solution were respectively prepared. A solution (A) in which methanol, pure water, and aqueous ammonia were mixed in advance at 10.0:1.1:1 (mass ratio) was charged in a reaction tank equipped with a thermometer, a stirrer, a supply pipe, and a distillation line. The concentration of ammonia in the solution (A) was 2.4% by mass. Further, ammonium hydrogen carbonate was added to the solution (A). The molar ratio of ammonium hydrogen carbonate to ammonia was 0.00125:1.

While maintaining the temperature of the reaction solution at 50°C, 63.6 parts by volume of the solution (B) and 24.6 parts by volume of the solution (C) were added to 100 parts by volume the solution (A) at a constant rate over 153 minutes to obtain a dispersion of silica particles. The dispersion of the obtained silica particles was adjusted by adding pure water so that the content of the silica particles was about 20% by mass, and methanol and ammonia were removed by increasing the temperature to obtain a dispersion of silica particles having a silica particle content of about 20% by mass. When the obtained silica particles were observed with a scanning electron microscope, no fine particles were detected.

### [Example 4]

A dispersion of silica particles was obtained in the same manner as in Example 3 except that the molar ratio of ammonium hydrogen carbonate to ammonia in the solution (A) was set to 0.00250:1. When the obtained silica particles were observed with a scanning electron microscope, no fine particles were detected.

### [Example 5]

A dispersion of silica particles was obtained in the same manner as in Example 3 except that the molar ratio of ammonium hydrogen carbonate to ammonia in the solution (A) was set to 0.00375: 1. When the obtained silica particles were observed with a scanning electron microscope, no fine particles were detected.

### [Example 6]

A dispersion of silica particles was obtained in the same manner as in Example 3 except that the molar ratio of ammonium hydrogen carbonate to ammonia in the solution (A) was set to 0.00500:1. When the obtained silica particles were observed with a scanning electron microscope, no fine particles were detected.

### [Example 7]

A dispersion of silica particles was obtained in the same manner as in Example 3 except that the molar ratio of ammonium hydrogen carbonate to ammonia in the solution (A) was set to 0.00876: 1. When the obtained silica particles were observed with a scanning electron microscope, no fine particles were detected.

### [Comparative Example 1]

A dispersion of silica particles was obtained in the same manner as in Example 1 except that ammonium hydrogen carbonate was not added to the solution (A). When the obtained silica particles were observed with a scanning electron microscope, no fine particles were detected. In Table 1, "-" indicates that data has not been obtained.

### [Comparative Example 2]

A dispersion of silica particles was obtained in the same manner as in Example 1 except that ammonium hydrogen carbonate was not added to the solution (A) and the temperature of the reaction solution was maintained at 35°C.

### [Comparative Example 3]

As the silica particle dispersion of Comparative Example 3, a silica particle dispersion "PL-3" manufactured by Fuso Chemical Co., Ltd. was used.

### [Comparative Example 4]

As the silica particle dispersion of Comparative Example 4, a silica particle dispersion "PL-7" manufactured by Fuso Chemical Co., Ltd. was used.

### [Comparative Example 5]

The production of silica particles was attempted in the same manner as in Example 3 except that the molar ratio of ammonium hydrogen carbonate to ammonia in the solution (A) was 5: 100, but as soon as the solution (B) and the solution (C) were started to be added to the solution (A), the silica was aggregated and the production could not be continued.
When the obtained silica particles were observed with a scanning electron microscope, no fine particles were detected.

### [Table 1]

**Table 1**

| | Characteristics of silica particles | | | | | | | | | | Characteristics of silica sol | | Evaluation |
|---|---|---|---|---|---|---|---|---|---|---|---|---|---|
| | Secondary particle diameter [nm] | True specific gravity [g/mL] | Primary particle diameter [nm] | Association ratio | cv value [%] | Amount of silanol group [wt%] | Average long diameter [nm] | Average short diameter [nm] | Long diameter / short diameter | -0.0018x+2.032 | Silica concentration [mass%] | Ammonia concentration [mass ppm] | Polishing rate |
| Example 1 | 63.0 | 1.93 | 32.2 | 1.95 | 27..3 | 1.45 | 49.32 | 41.72 | 1.18 | 1.92 | 21.4 | 68.51 | A |
| Example 2 | 87.8 | 1.91 | 43.4 | 2.02 | 27.1 | 1.42 | 60.65 | 52.61 | 1.15 | 1.87 | 21.9 | 72.29 | A |
| Example 3 | 105.8 | 1.88 | 62.7 | 1.69 | 21.4 | 1.43 | 96.52 | 86.29 | 1.12 | 1.84 | 21.2 | 55.05 | A |
| Example 4 | 144.9 | 1.85 | 87.8 | 1.65 | 21.1 | 1.44 | 127.60 | 116.00 | 1.10 | 1.77 | 22.4 | 69.25 | A |
| Example 5 | 182.0 | 1.84 | 112.9 | 1.61 | 22.1 | 1.41 | 18020 | 157.20 | 1.15 | 1.70 | 22.9 | 50.80 | A |
| Example 6 | 220.9 | 1.84 | 142.6 | 1.55 | 20.3 | 1.42 | 216.50 | 196.10 | 1.10 | 1.63 | 22.7 | 48.85 | A |
| Example 7 | 392.5 | 1.80 | 247.6 | 1.59 | 22.5 | 1.35 | 362.10 | 332.00 | 1.09 | 1.33 | 22.6 | 53.49 | A |
| Comparative Example 1 | 44.6 | 1.96 | 24.3 | 1.83 | 31.9 | 1.48 | - | - | - | 1.95 | 22.7 | - | B |
| Comparative Example 2 | 129.9 | 1.78 | 77.3 | 1.68 | 20.5 | 1.49 | 118.30 | 112.20 | 1.05 | 1.80 | 21.7 | 59.38 | C |
| Comparative Example 3 | 68.4 | 1.81 | 36.5 | 1.88 | 28.6 | 1.11 | 55.90 | 47.10 | 1.19 | 1.91 | 19.6 | 102.87 | C |
| Comparative Example 4 | 131.9 | 1.73 | 82.1 | 1.61 | 22.0 | 0.31 | 117.90 | 111.90 | 1.05 | 1.79 | 23.1 | 64.94 | C |

As can be seen from Table 1, the silica particles of Examples 1 to 7 satisfied the above formulae (1a) and (1b), and the silica particles of Comparative Examples 1 to 4 did not satisfy any of the above formulae (1a) and (1b). The true specific gravity of the silica particles of Examples 1 to 7 was larger than that of the silica particles of Comparative Examples 1 to 4 having the same particle diameter.

Since the ratio of the average secondary particle diameter to the true specific gravity is in a desired range, it is considered that when the silica particles of Examples 1 to 7 are used for polishing, an excellent polishing rate is exhibited.

Various embodiments have been described above, but the present invention is of course not limited to such embodiments. It would be apparent to a person skilled in the art that various changes and modifications can be made within the scope of the claims, and it would be understood that such changes and modifications would naturally fall within the technical scope of the present invention. In addition, the constituent elements in the above-described embodiments may be arbitrarily combined within a scope that does not depart from the spirit of the invention.

The present application is based on the Japanese patent application (JP2023-214121) filed on December 19, 2023, and the contents thereof are incorporated herein by reference.

### INDUSTRIAL APPLICABILITY

The silica particles of the present invention can be used for polishing a semiconductor material such as a silicon wafer, polishing an electronic material such as a hard disk substrate, polishing (chemical mechanical polishing) in a planarization step when producing an integrated circuit, polishing of a synthetic quartz glass substrate used for a photomask or a liquid crystal, polishing of a magnetic disk substrate, and the like.

## Claims

1. Silica particles satisfying the following formulae (1a) and (1b) when an average secondary particle diameter is x (nm) and a true specific gravity is y (g/mL): $y > - 0.0018 x + 2.032$ (1a) $x > 50$ (1b).

2. The silica particles according to claim 1, wherein the silica particles satisfy the following formula (1c): $y > - 0.0018 x + 2.062$ (1c).

3. The silica particles according to claim 1, wherein the silica particles satisfy the following formula (1d): $x \geq 55$ (1d).

4. The silica particles according to claim 1, wherein the silica particles have a metal impurity content of 5 ppm by mass or less.

5. The silica particles according to claim 1, wherein the silica particles satisfy the following formula (1e): $y \leq 2.10$ (1e).

6. The silica particles according to claim 1, wherein the silica particles have a refractive index of 1.380 or more.

7. The silica particles according to claim 1, wherein an average primary particle diameter is 15 nm to 700 nm.

8. The silica particles according to claim 1, wherein an amine content is less than 5 µmol/g.

9. A method for producing the silica particles according to any one of claims 1 to 8, the method comprising a step of subjecting an alkoxysilane to hydrolysis and condensation reaction in a solution containing a salt.

10. The method for producing the silica particles according to claim 9, wherein the salt is decomposed or volatilized when heated to 100°C.

11. The method for producing the silica particles according to claim 9, wherein the alkoxysilane is subjected to hydrolysis and condensation reaction using an alkali catalyst.

12. The method for producing the silica particles according to claim 11, wherein a molar ratio of an amount of the salt to an amount of the alkali catalyst contained in the solution at the start of the reaction in the step of subjecting alkoxysilane to hydrolysis and condensation reaction in the solution containing the salt is 1.0×10⁻⁴ to 4.5×10⁻².

13. A silica sol comprising the silica particles according to any one of claims 1 to 8.

14. A polishing composition comprising the silica sol according to claim 13.

15. A polishing method comprising polishing by using the polishing composition according to claim 14.

16. A method for producing a semiconductor wafer, the method comprising a step of polishing by using the polishing composition according to claim 14.

17. A method for producing a semiconductor device, the method comprising a step of polishing by using the polishing composition according to claim 14.
